# EUROPEAN PATENT APPLICATION

(11) **EP 4 629 244 A2**
(43) Date of publication of application: **08.10.2025**
(21) Application number: 25163431.7
(22) Date of filing: 13.03.2025
(51) Int. Cl.: G11C 11/412, G11C 11/417, H01L 21/768, H10B 10/00

(54) **SEMICONDUCTOR DEVICE**

(30) Priority: 05.04.2024 KR 20240046642
(71) Applicant: Samsung Electronics Co., Ltd., Suwon-si, Gyeonggi-do 16677 (KR)
(72) Inventor: KIM, Jee Woong, 16677 Suwon-si (KR); KIM, Jin Kyu, 16677 Suwon-si (KR); NAM, Yun Suk, 16677 Suwon-si (KR); CHO, Keun Hwi, 16677 Suwon-si (KR)
(74) Representative: Marks & Clerk LLP

(57) **Abstract**

A semiconductor device includes: first and second unit cell areas adjacent one another in a first direction; a third unit cell area adjacent the first unit cell area in a second direction; a tap cell area arranged with the first unit cell area along the first direction; a bit-line and complementary bit-line each extending in the second direction on a first surface of a substrate and connected to the first and third unit cell areas; and a word-line extending in the first direction on a second surface of the substrate and connected to the first and second unit cell areas. Each of the first to third unit cell areas includes: first and second inverters forming a latch circuit; and first and second pass transistors connecting the latch circuit to the bit-line and complementary bit-line. The tap cell area electrically connects the first and second pass transistors and the word-line.

## Description

### BACKGROUND

The present disclosure relates generally to a semiconductor device. More specifically, the present disclosure relates to a semiconductor device including a backside power delivery network (BSPDN).

Due to characteristics such as miniaturization, multi-functionality, and/or low manufacturing cost, a semiconductor device is attracting attention as an important element in the electronics industry. The semiconductor devices may be classified into a semiconductor memory device that stores therein logical data, a semiconductor logic device that computes and processes logical data, and a hybrid semiconductor device that includes a memory element and a logic element.

As the electronics industry develops, demand for the characteristics of the semiconductor device is increasing. For example, demand for high reliability, high speed, and/or multifunctionality of the semiconductor device is increasing. In order to meet these required characteristics, structures within the semiconductor device are becoming increasingly complex and highly integrated with each other.

### SUMMARY

A technical purpose that the present disclosure seeks to achieve is to provide a semiconductor device with improved DOF (degree of freedom) in design and an improved integration density.

Purposes according to the present disclosure are not limited to the above-mentioned purpose. Other purposes and advantages according to the present disclosure that are not mentioned may be understood based on the following descriptions, and may be more clearly understood based on embodiments according to the present disclosure. Further, it will be easily understood that the purposes and advantages according to the present disclosure may be realized using means illustrated in the claims and combinations thereof.

According to an aspect of the present inventive concept, there is provided a semiconductor device comprising a substrate including a first surface and a second surface opposite to each other, first and second active patterns on the first surface, the first and second active patterns extending in a first direction in a parallel manner, first to fourth gate structures arranged sequentially along the first direction on the first and second active patterns, the first to fourth gate structures extending in a second direction intersecting the first direction in a parallel manner, a first source/drain contact between the first gate structure and the second gate structure, the first source/drain contact connecting the first active pattern and the second active pattern, a second source/drain contact between the third gate structure and the fourth gate structure, the second source/drain contact connecting the first active pattern and the second active pattern, a third source/drain contact connected to the first active pattern, the first gate structure being interposed between the first source/drain contact and the third source/drain contact, a fourth source/drain contact connected to the first active pattern, the fourth gate structure being interposed between the second source/drain contact and the fourth source/drain contact, a first front wiring pattern extending in the first direction on the first surface, the first front wiring pattern being connected to the third source/drain contact, a second front wiring pattern extending in the first direction on the first surface, the second front wiring pattern connecting the second gate structure and the second source/drain contact, a third front wiring pattern extending in the first direction on the first surface, the third front wiring pattern connecting the third gate structure and the first source/drain contact, a fourth front wiring pattern extending in the first direction on the first surface, the fourth front wiring pattern being connected to the fourth source/drain contact, a first back wiring pattern extending in the first direction on the second surface, the first back wiring pattern being connected to the first active pattern between the second gate structure and the third gate structure, a second back wiring pattern extending in the first direction on the second surface, the second back wiring pattern being connected to the second active pattern between the second gate structure and the third gate structure, and a third back wiring pattern extending in the second direction on the second surface, the third back wiring pattern is commonly connected to the first gate structure and the fourth gate structure.

According to an aspect of the present inventive concept, there is provided a semiconductor device including a first area and a second area arranged along a first direction, the semiconductor device comprising a substrate including a first surface and a second surface opposite to each other, first and second active patterns on the first surface of the first area, the first and second active patterns extending in a second direction intersecting the first direction in a parallel manner, first to fourth gate structures arranged sequentially along the second direction on the first and second active patterns, the first to fourth gate structures extending in the first direction in a parallel manner, a first front wiring pattern extending in the second direction on the first surface of the first area, the first front wiring pattern being connected to the first active pattern on one side of the first gate structure, a second front wiring pattern disposed extending in the second direction on the first surface of the first area, the second front wiring pattern being connected to the first active pattern on one side of the fourth gate structure, a third front wiring pattern extending in the second direction on the first surface of the second area, the third front wiring pattern connecting the first gate structure and the fourth gate structure, a first back wiring pattern extending in the second direction on the second surface of the first area, the first back wiring pattern being connected to the first active pattern between the second gate structure and the third gate structure, a second back wiring pattern extending in the second direction on the second surface of the first area, the second back wiring pattern being connected to the second active pattern between the second gate structure and the third gate structure, a third back wiring pattern extending in the first direction on the second surface of the first area and the second area, and a through-contact extending through the substrate of the second area, the through-contact connecting the third front wiring pattern and the third back wiring pattern.

According to an aspect of the present inventive concept, there is provided a semiconductor device comprising a first unit cell area, a second unit cell area adjacent to the first unit cell area in a first direction, and a third unit cell area adjacent to the first unit cell area in a second direction intersecting the first direction, and a tap cell area arranged with the first unit cell area along the first direction, wherein the semiconductor device comprises a substrate including a first surface and a second surface opposite to each other, a bit-line extending in the second direction on the first surface, the bit-line being commonly connected to the first and third unit cell areas, a complementary bit-line extending in the second direction on the first surface, the complementary bit-line being commonly connected to the first and third unit cell areas, and a word-line extending in the first direction on the second surface, the word-line being commonly connected to the first and second unit cell areas, wherein each of the first to third unit cell areas includes first and second inverters constituting one latch circuit, a first pass transistor connecting an output node of the first inverter and the bit-line, and a second pass transistor connecting an output node of the second inverter and the complementary bit-line, wherein the tap cell area electrically connects a gate of the first pass transistor, a gate of the second pass transistor and the word-line.

The following features may apply to any of the above described aspects.

The substrate is a semiconductor substrate (e.g. comprising silicon).

A number of components (e.g. the front wiring patterns) are arranged on the first surface of the substrate, i.e. the components are arranged on the side of the substrate given by the first surface. However, for at least some of these components, intermediate layers (e.g. insulating layers) may be arranged between the substrate and these components.

The second direction intersects the first direction. The second direction may be perpendicular to the first direction.

The semiconductor device comprises source/drain regions separated one from another by the gate structures. Different ones of the source/drain regions may be connected to different ones of the source/drain contacts. Each of some of the source/drain regions is connected to one of the source/drain contacts (e.g. contact 171 to 174). The first active pattern (AP1) and the second active pattern (AP2) may each comprise separate source/drain regions. One of the source/drain regions of each of the first active pattern and the second active pattern may be connected to back source/drain contacts (e.g. contacts 301 or 302) The source/drain regions belonging to either one of the active patterns may be collectively referred to as a source/drain area of the first active pattern or the second active pattern.

In some embodiments, the semiconductor device further comprises: a fifth front wiring pattern extending in the first direction on the first surface and electrically connecting the first gate structure and the fourth gate structure; and a through-contact between the first gate structure and the fourth gate structure, the through-contact extends in the substrate and electrically connects the third back wiring pattern and the fifth front wiring pattern. The through-contact connects through the substrate to connect the third back wiring pattern and the fifth front wiring pattern.

In some embodiments, the substrate includes a first area and a second area arranged along the second direction. The first area and the second area are adjacent to one another in the second direction. The first and second active patterns are on the first area, the fifth front wiring pattern is on the second area, and each of the first gate structure and the fourth gate structure extends in the second direction across the first area and the second area. The first and second back wiring patterns are in the first area. The third back wiring pattern may be at least in the second area.

In some embodiments, the first back wiring pattern is configured to receive a first power voltage. The second back wiring pattern is configured to receive a second power voltage different from the first power voltage. In some embodiments, the semiconductor device comprise means for supplying a first power voltage to the first back wiring pattern and a means for supplying a second power voltage to the second back wiring pattern.

At least some of the above and other features of the invention are set out in the claims.

### BRIEF DESCRIPTION OF DRAWINGS

The above and other aspects and features of the present disclosure will become more apparent by describing in detail embodiments thereof with reference to the attached drawings, wherein like reference numerals (when used) indicate corresponding elements throughout the several views, and in which:
FIG. 1 is an example block diagram for illustrating a semiconductor device according to some embodiments;
FIG. 2 is a circuit diagram for illustrating the unit cell area UC of a semiconductor device according to some embodiments;
FIG. 3 is an example schematic layout diagram for illustrating a unit cell area of a semiconductor device according to some embodiments;
FIG. 4 is a schematic cross-sectional view taken along line A-A shown in FIG. 3;
FIG. 5 is a schematic cross-sectional view taken along line B-B shown in FIG. 3;
FIG. 6 is a schematic cross-sectional view taken along line C-C shown in FIG. 3.
FIG. 7 is a schematic cross-sectional view taken along line D-D shown in FIG. 3;
FIG. 8 is an example schematic layout diagram for illustrating a tap cell (TC) area of a semiconductor device according to some embodiments;
FIG. 9 is a schematic cross-sectional view taken along line E-E shown in FIG. 8;
FIG. 10 is an example schematic layout diagram for illustrating the unit cell area of the semiconductor device according to some embodiments;
FIG. 11 is an example block diagram for illustrating a semiconductor device according to some embodiments;
FIG. 12 is a circuit diagram for illustrating a semiconductor device according to some embodiments; and
FIG. 13 and FIG. 14 are example layouts for illustrating the semiconductor device shown in FIG. 12.

### DETAILED DESCRIPTION

Although terms such as first, second, upper, and lower may be used herein to describe various elements or components, it is to be understood that these elements or components are not limited by such terms. Rather, these terms are merely used herein to distinguish one element or component from another element or component. Therefore, it is to be appreciated that a first element or component as mentioned below may also be referred to as a second element or component. Further, it is to be understood that a lower element or component as mentioned below may also be referred to as an upper element or component.

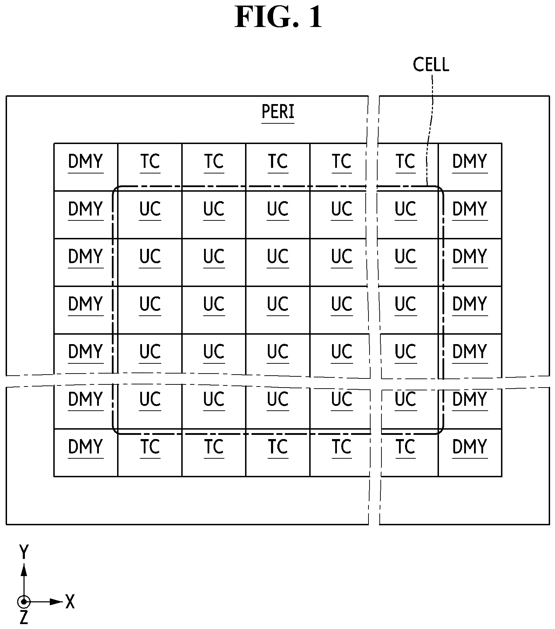

Hereinafter, with reference to FIG. 1 to FIG. 14, a semiconductor device according to some embodiments is described. In embodiments as disclosed below, an example in which a semiconductor device is embodied as a static random access memory (SRAM) device is described. However, this is only an example. A person with ordinary knowledge in the technical field to which the present disclosure belongs will appreciate that the technical ideas of the present disclosure may be applied not only to the SRAM device but also to various other semiconductor devices such as logic devices.

FIG. 1 is an example block diagram for illustrating a semiconductor device according to some embodiments.

Referring to FIG. 1, the semiconductor device according to some embodiments includes a cell array area CELL, a peripheral area PERI, a dummy cell area DMY, and a tap cell area TC.

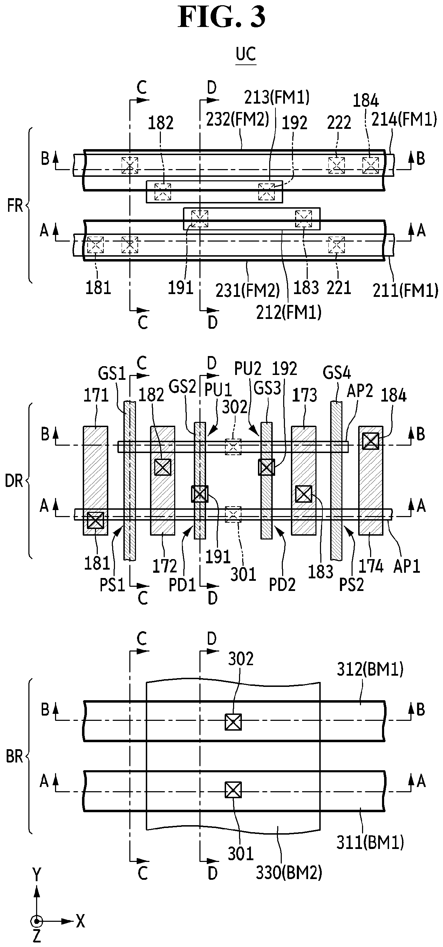

The cell array area CELL may include a plurality of unit cell areas UC. The plurality of unit cell areas UC may be arranged two-dimensionally, for example, along a horizontal plane (e.g., an X-Y plane including a first direction X and a second direction Y that intersect each other and are parallel to an upper surface of the semiconductor device). Each unit cell area UC will be described in detail later with reference to FIG. 3 to FIG. 7. As used herein, each unit cell area UC may be referred to as a first area.

The peripheral area PERI may be a core/peripheral area formed around the cell array area CELL. The peripheral area PERI may include control elements and/or dummy elements for controlling a function of each unit cell area UC formed within the cell array area CELL. The peripheral area PERI is shown only surrounding the cell array area CELL. However, this is only an example, and the cell array area CELL and the peripheral area PERI may be arranged in various other forms. The term "surrounding" (or "surrounds," or like terms), as may be used herein, is intended to broadly refer to an element, structure or layer that extends around, envelops, encircles, or encloses another element, structure or layer on all sides, although breaks or gaps may also be present. Thus, for example, a material layer having voids or gaps therein may still "surround" another layer which it encircles.

The dummy cell area DMY may be disposed along at least a portion of an edge of the cell array area CELL. For example, the dummy cell area DMY may be between the cell array area CELL and the peripheral area PERI. The dummy cell area DMY may be used to prevent pattern defects that may otherwise occur at the edge of the cell array area CELL. The dummy cell area DMY may be arranged in the second direction Y.

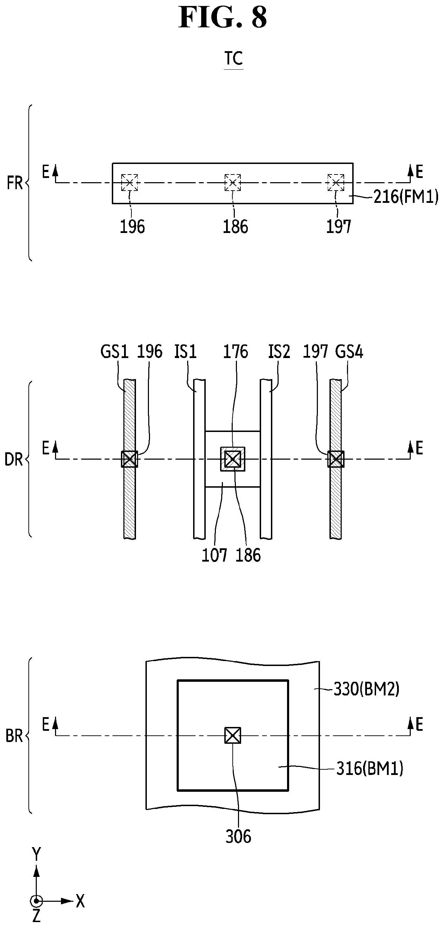

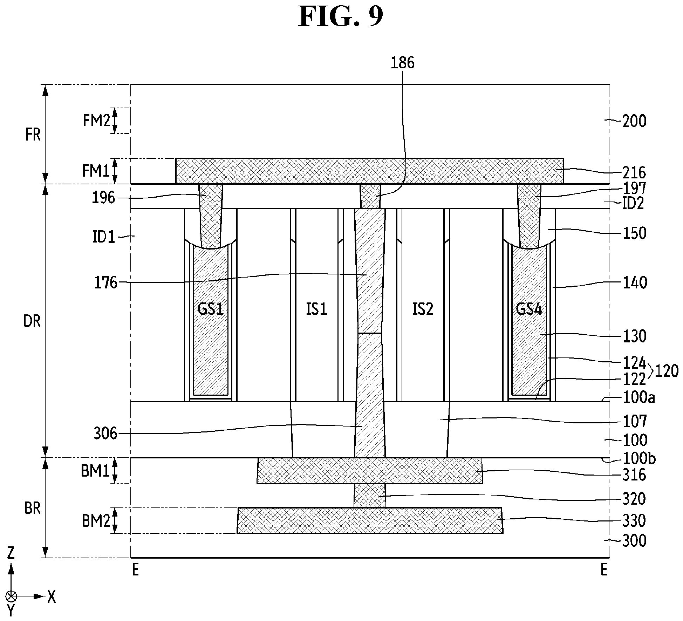

The tap cell areas TC may be arranged in the first direction X and along an edge of the cell array area CELL. The tap cell areas TC and the cell array area CELL may be arranged in the second direction Y. For example, the tap cell area TC may be between the cell array area CELL and the peripheral area PERI in the second direction Y. The tap cell areas TC and a plurality of unit cell areas UC may be arranged along the second direction Y. The tap cell area TC may be used to communicate a signal between the cell array area CELL and the peripheral area PERI. The tap cell area TC is described in detail later with reference to FIG. 8 and FIG. 9. As used herein, the tap cell area TC may also be referred to as a second area.

In some embodiments, the tap cell area TC may be located within the dummy cell area DMY.

In some embodiments, the tap cell areas TC may be disposed on each of both opposing sides in the second direction Y of the cell array area CELL.

In some embodiments, a plurality of tap cell areas TC may be arranged along the first direction X.

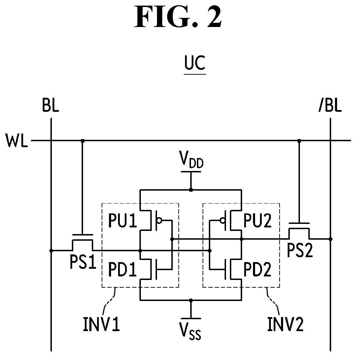

FIG. 2 is a circuit diagram for illustrating the unit cell area UC of a semiconductor device according to some embodiments.

Referring to FIG. 2, the unit cell area UC of the semiconductor device according to some embodiments includes a pair of inverters INV1 and INV2 connected in parallel with each other and disposed between and connected to a power node V_{DD} and a ground node V_{SS}, and a first pass transistor PS 1 and a second pass transistor PS2 respectively connected to output nodes of the inverters INV1 and INV2.

The pair of inverters INV1 and INV2 may be configured in a cross-coupled arrangement to form a latch circuit. To configure one latch circuit, an input node of the first inverter INV1 may be connected to the output node of the second inverter INV2, and an input node of the second inverter INV2 may be connected to the output node of the first inverter INV1.

The first inverter INV1 may include a first pull-up transistor PU1 and a first pull-down transistor PD1 connected in series with each other between the power node V_{DD} and ground node V_{SS}. The second inverter INV2 may include a second pull-up transistor PU2 and a second pull-down transistor PD2 connected in series with each other between the power node V_{DD} and ground node V_{SS}. Each of the first pull-up transistor PU1 and the second pull-up transistor PU2 may be a PFET, while each of the first pull-down transistor PD1 and the second pull-down transistor PD2 may be a NFET.

The first pass transistor PS1 may selectively connect a bit-line BL and the output node of the first inverter INV1 to each other. The second pass transistor PS2 may selectively connect a complementary bit-line /BL and the output node of the second inverter INV2 to each other. A gate of the first pass transistor PS1 and a gate of the second pass transistor PS2 may be connected to a word-line WL.

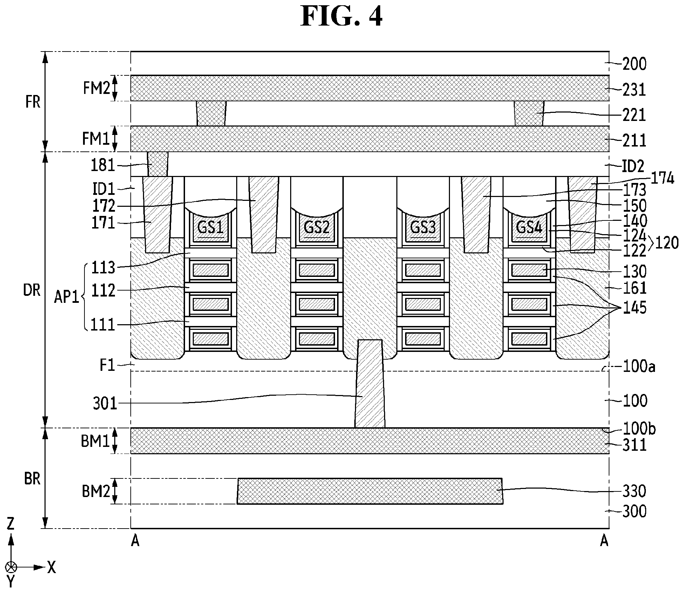

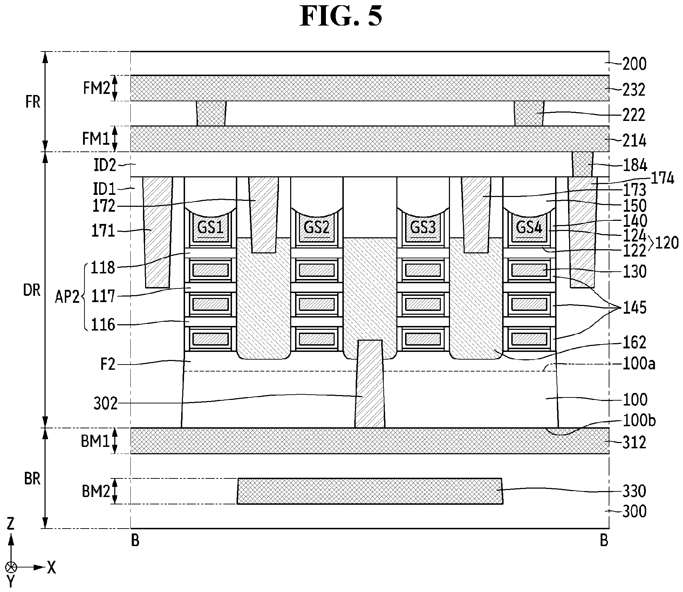

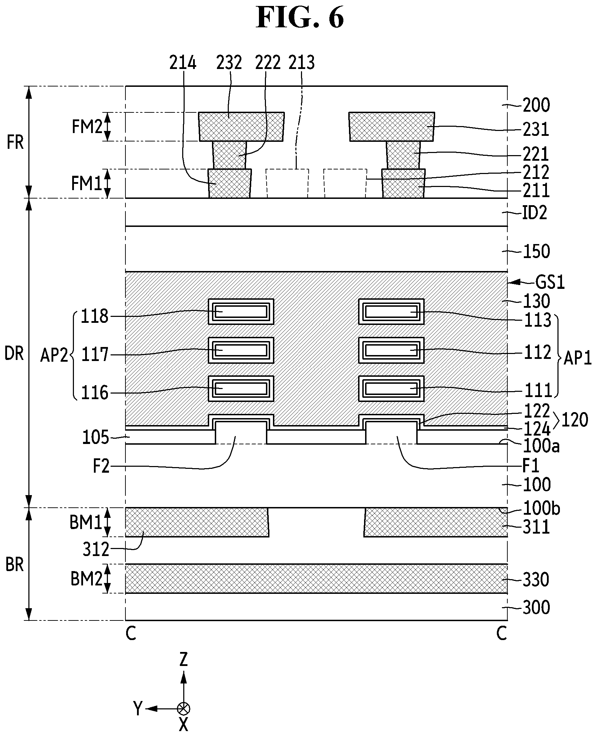

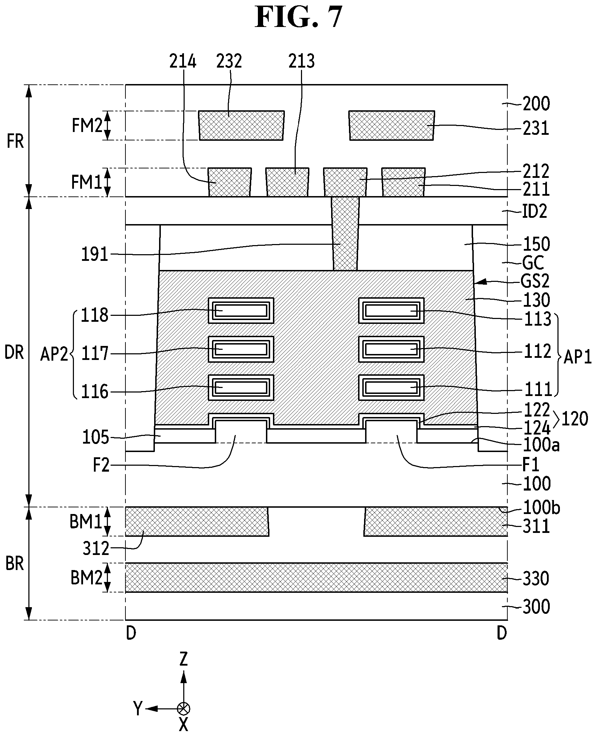

FIG. 3 is an example schematic layout diagram (i.e., top plan view) illustrating a unit cell area of a semiconductor device according to some embodiments. FIG. 4 is a schematic cross-sectional view taken along line A-A shown in FIG. 3. FIG. 5 is a schematic cross-sectional view taken along line B-B shown in FIG. 3. FIG. 6 is a schematic cross-sectional view taken along line C-C shown in FIG. 3. FIG. 7 is a schematic cross-sectional view taken along line D-D shown in FIG. 3. FIG. 8 is an example schematic layout diagram illustrating the tap cell area of a semiconductor device according to some embodiments. FIG. 9 is a schematic cross-sectional view taken along line E-E shown in FIG. 8.

Referring to FIG. 1 to FIG. 9, a semiconductor device according to some embodiments includes an element area DR, a front area FR, and a back area BR.

The element area DR may include a substrate 100, a field insulating film 105, first and second active patterns AP1 and AP2, first to fourth gate structures GS1 to GS4, source/drain contacts 171 to 174, a first interlayer insulating film ID1 and a second interlayer insulating film ID2.

The substrate 100 may be made of bulk silicon or SOI (silicon-on-insulator). Alternatively, the substrate 100 may be a silicon substrate, or may include a material other than that of silicon, such as silicon germanium, silicon germanium on insulator (SGOI), indium antimonide, lead telluride compound, indium arsenide, indium phosphide, gallium arsenide, or gallium antimonide, although embodiments are not limited thereto. Alternatively, the substrate 100 may have a base substrate and an epitaxial layer formed on the base substrate.

In some embodiments, the substrate 100 may be an insulating substrate including an insulating material. For example, the substrate 100 may include at least one of silicon oxide, silicon oxynitride, silicon oxycarbonitride, and combinations thereof However, embodiments of the present disclosure are not limited thereto. For example, the substrate 100 may include a silicon oxide film.

The substrate 100 may include a first surface 100a and a second surface 100b, which are opposite to each other in a third direction Z perpendicular to the first surface 100a. As used herein, the first surface 100a may be referred to as a front surface of the substrate 100. The second surface 100b may be referred to as a back surface of the substrate 100.

The first and second active patterns AP1 and AP2 may be formed on the first surface 100a of the unit cell area UC. The first and second active patterns AP1 and AP2 may be spaced apart from each other in the second direction Y and extend in a parallel manner to each other in the first direction X. For example, each of the first and second active patterns AP1 and AP2 may extend in an elongate manner in the first direction X, and the first and second active patterns AP1 and AP2 may be arranged sequentially along the second direction Y. In some embodiments, the first active pattern AP1 may extend in an elongate manner in the first direction X beyond the unit cell area UC.

Each of the first and second active patterns AP1 and AP2 may include silicon (Si) or germanium (Ge) as an elemental semiconductor material. Alternatively, each of the first and second active patterns AP1 and AP2 may include a compound semiconductor, for example, a group IV-IV compound semiconductor or a group III-V compound semiconductor. The group IV-IV compound semiconductor may include, for example, a binary compound including two of carbon (C), silicon (Si), germanium (Ge), and tin (Sn), a ternary compound including three thereof, or a compound obtained by doping a group IV element thereto. The group III-V compound semiconductor may include, for example, a binary compound obtained by combining one of aluminum (Al), gallium (Ga), and indium (In) as a group III element and one of phosphorus (P), arsenic (As), and antimony (Sb) as a group V element with each other, a ternary compound obtained by combining two of aluminum (Al), gallium (Ga), and indium (In) as a group III element and one of phosphorus (P), arsenic (As), and antimony (Sb) as a group V with each other, or a quaternary compound obtained by combining three of aluminum (Al), gallium (Ga), and indium (In) as a group III element and one of phosphorus (P), arsenic (As), and antimony (Sb) as a group V with each other.

In some embodiments, the first active pattern AP1 may be used as a channel area of the NFET. The second active pattern AP2 may be used as a channel area of the PFET.

In some embodiments, each of the first and second active patterns AP1 and AP2 may include a plurality of bridge patterns that are sequentially stacked on the substrate 100 and are spaced apart from each other in the third direction Z. For example, the first active pattern AP1 may include first to third bridge patterns 111 to 113. The second active pattern AP2 may include fourth to sixth bridge patterns 116 to 118. Each of the first and second active patterns AP1 and AP2 may be used as a channel area of a multi-bridge-channel field-effect transistor (MBCFET^{®}, a registered trademark of Samsung Electronics Co., Ltd.) including a multi-bridge channel. The number of bridge patterns included in each of the first and second active patterns AP1 and AP2 is only an example, and is not limited to what is shown.

In some embodiments, a first fin-shaped pattern F1 may be formed between the substrate 100 and the first bridge pattern 111 in the third direction Z, and a second fin-shaped pattern F2 may be formed between the substrate 100 and the fourth bridge pattern 116 in the third direction Z. Each of the first and second fin-shaped patterns F1 and F2 may protrude from the first surface 100a of the substrate 100 and extend in the first direction X. In some embodiments, each of the first and second fin-shaped patterns F1 and F2 may be an insulating pattern including an insulating material.

The field insulating film 105 may be formed on the substrate 100. In some embodiments, the field insulating film 105 may cover at least a portion of a side surface of each of the first and second fin-shaped patterns F1 and F2. The field insulating film 105 may include, but is not limited to, at least one of silicon oxide, silicon nitride, silicon oxynitride, and combinations thereof.

The first to fourth gate structures GS1 to GS4 may be formed on the substrate 100 and the field insulating film 105. The first to fourth gate structure GS1 to GS4 may be formed on the first and second active patterns AP1 and AP2. The first to fourth gate structures GS1 to GS4 may be spaced apart from each other in the first direction X and extend in a parallel manner to each other and in the second direction Y. For example, the first to fourth gate structures GS1 to GS4 may extend longitudinally in the second direction Y and may be arranged sequentially along the first direction X.

The first gate structure GS1 may intersect with the first active pattern AP1. For example, each of the first to third bridge patterns 111 to 113 may extend in the first direction X and extend through the first gate structure GS1. The first gate structure GS1 may serve as a gate of the first pass transistor PS1. For example, an area of the first active pattern AP1 that intersects the first gate structure GS1 may serve as a channel area of the first pass transistor PS1.

The second gate structure GS2 may intersect the first active pattern AP1 and the second active pattern AP2. For example, each of the first to third bridge patterns 111 to 113 and the fourth to sixth bridge patterns 116 to 118 may extend in the first direction X and extend through the second gate structure GS2. The second gate structure GS2 may serve as a gate of the first inverter INV1. For example, an area of the first active pattern AP1 that intersects the second gate structure GS2 may be provided as a channel area of the first pull-down transistor PD1. An area of the second active pattern AP2 that intersects the second gate structure GS2 may serve as a channel area of the first pull-up transistor PU1.

The third gate structure GS3 may intersect with the first active pattem AP1 and the second active pattern AP2. For example, the first to third bridge patterns 111 to 113 and the fourth to sixth bridge patterns 116 to 118 may extend in the first direction X and extend through the third gate structure GS3. The third gate structure GS3 may serve as a gate of the second inverter INV2. For example, an area of the first active pattern AP1 that intersects the third gate structure GS3 may be provided as a channel area of the second pull-down transistor PD2. An area of the second active pattern AP2 that intersects the third gate structure GS3 may serve as a channel area of the second pull-up transistor PU2.

The fourth gate structure GS4 may intersect the first active pattern AP1. For example, each of the first to third bridge patterns 111 to 113 may extend in the first direction X and extend through the fourth gate structure GS4. The fourth gate structure GS4 may serve as a gate of the second pass transistor PS2. For example, an area of the first active pattern AP1 that intersects the fourth gate structure GS4 may serve as a channel area of the second pass transistor PS2.

In some embodiments, each of the second and third gate structures GS2 and GS3 may be cut by a cutting pattern GC. For example, the cutting pattern GC may be disposed on one side of the first active pattern AP1 opposite to the other side thereof facing the second active pattern AP2, and may extend in the first direction X so as to cut the second and the third gate structures GS2 and GS3. Furthermore, for example, the cutting pattern GC may be disposed on one side of the second active pattern AP2 opposite to the other side thereof facing the first active pattern AP1, and may extend in the first direction X so as to cut the second and the third gate structures GS2 and GS3.

In some embodiments, each of the first and fourth gate structures GS1 and GS4 may not be cut by the cutting pattern GC. For example, the cutting pattern GC that cuts the second and third gate structures GS2 and GS3 may be disposed between the first gate structure GS1 and the fourth gate structure GS4. The cutting pattern GC cutting the second and third gate structures GS2 and GS3 may be spaced apart from the first and fourth gate structures GS1 and GS4 in the first direction X.

In some embodiments, each of the first and fourth gate structures GS1 and GS4 may extend longitudinally in the second direction Y beyond the unit cell area UC. In some embodiments, each of the first and fourth gate structures GS1 and GS4 may extend longitudinally in the second direction Y across the unit cell area UC and the tap cell area TC.

The cutting pattern GC may include an insulating material, such as at least one of silicon oxide, silicon nitride, silicon oxynitride, silicon oxycarbide, silicon boron nitride, silicon boron carbonitride, silicon oxycarbonitride, and combinations thereof. However, embodiments of the present disclosure are not limited thereto.

Each of the first to fourth gate structures GS1 to GS4 may include a gate dielectric film 120, a gate electrode 130, a gate spacer 140, and a gate capping film 150.

The gate dielectric film 120 may be interposed between each of the first and second active patterns AP1 and AP2 and the gate electrode 130. The gate dielectric film 120 may include a dielectric material, for example, at least one of silicon oxide, silicon oxynitride, silicon nitride, or a high dielectric constant material having a higher dielectric constant than that of silicon oxide. The high dielectric constant material may include at least one of, for example, hafnium oxide, hafnium silicon oxide, hafnium aluminum oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, lead zinc niobate and combinations thereof. However, embodiments of the present disclosure are not limited thereto.

The gate electrode 130 may extend longitudinally in the second direction Y and intersect the first and/or second active patterns AP1 and AP2. For example, each of the bridge patterns 111 to 113 and 116 to 118 may extend in the first direction X and extend through the gate electrode 130. The gate electrode 130 may include a conductive material such as at least one of, such as TiN, WN, TaN, Ru, TiC, TaC, Ti, Ag, Al, TiAl, TiAlN, TiAlC, TaCN, TaSiN, Mn, Zr, W, Al, or combinations thereof. However, embodiments of the present disclosure are not limited thereto. The gate electrode 130 may be formed by a replacement gate process. However, embodiments of the present disclosure are not limited thereto.

The gate electrode 130 is shown as being formed as a single film. However, this is only an example. In another example, the gate electrode 130 may be formed by stacking a plurality of conductive films. For example, the gate electrode 130 may include a work function control film that adjusts a work function, and a filling conductive film that fills a space formed by the work function control film. For example, the work function control film may include at least one of TiN, TaN, TiC, TaC, TiAlC, or combinations thereof. For example, the filling conductive film may include W or Al.

The gate spacer 140 may extend along a side surface of the gate electrode 130. Each of the bridge patterns 111 to 113 and 116 to 118 may extend in the first direction X through the gate spacer 140. The gate spacer 140 may include an insulating material such as at least one of silicon oxide, silicon nitride, silicon oxynitride, silicon oxycarbide, silicon boron nitride, silicon boron carbonitride, silicon oxycarbonitride, or combinations thereof. However, embodiments of the present disclosure are not limited thereto.

In some embodiments, the gate dielectric film 120 may include an interfacial film 122 and a high dielectric constant film 124 that are sequentially stacked on the first and second active patterns AP1 and AP2.

The interfacial film 122 may surround (i.e., extend around) a perimeter of each of the bridge patterns 111 to 113 and 116 to 118. For example, the interfacial film 122 may extend conformally along the perimeter of each of the bridge patterns 111 to 113 and 116 to 118. The term "conformally" (or "conformal," or like terms), as may be used herein in the context of a material layer or coating, is intended to refer broadly to a material layer or coating having a substantially uniform cross-sectional thickness relative to the contour of a surface to which the material layer is applied. In some embodiments, the interfacial film 122 may include an oxide film formed by oxidizing a surface of each of the bridge patterns 111 to 113 and 116 to 118. For example, when each of the bridge patterns 111 to 113 and 116 to 118 includes silicon (Si), the interfacial film 122 may include a silicon oxide film.

The high dielectric constant film 124 may surround (i.e., extend around) a perimeter of the interfacial film 122. Furthermore, a portion of the high dielectric constant film 124 may be interposed between the gate electrode 130 and the gate spacer 140. For example, the high dielectric constant film 124 may extend conformally along a profile a combination of a perimeter of the interfacial film 122 and an inner side surface of the gate spacer 140. Furthermore, the high dielectric constant film 124 may extend further along a top surface of the field insulating film 105.

In some embodiments, the high dielectric constant film 124 may include a high dielectric constant material (high-k material) with a dielectric constant greater than that of silicon oxide. The high dielectric constant material may include at least one of for example, hafnium oxide (HfO₂), zirconium oxide (ZrO₂), lanthanum oxide (La₂O₃), aluminum oxide (Al₂O₃), titanium oxide (TiO₂), strontium titanium oxide (SrTiO₃), lanthanum aluminum oxide (LaAlO₃), yttrium oxide (Y₂O₃), hafnium oxynitride (HfOₓN_{y}), zirconium oxynitride (ZrOₓN_{y}), lanthanum oxynitride (La₂OₓN_{y}), aluminum oxynitride (Al₂OₓN_{y}), titanium oxynitride (TiOₓN_{y}), strontium titanium oxynitride (SrTiOₓN_{y}), lanthanum aluminum oxynitride (LaAlOₓN_{y}), yttrium oxynitride (Y₂OₓN_{y}) or combinations thereof. However, embodiments of the present disclosure are not limited thereto.

The gate capping film 150 may extend along an upper surface of the gate electrode 130. The gate capping film 150 may include an insulating material including at least one of silicon oxide, silicon nitride, silicon oxynitride, silicon oxycarbide, silicon boron nitride, silicon boron carbonitride, silicon oxycarbonitride, or combinations thereof. However, embodiments of the present disclosure are not limited thereto.

A first source/drain area 161 may be disposed on the first active pattern AP1 on sides of the first to fourth gate structures GS1 to GS4. The first to third bridge patterns 111 to 113 may extend through the gate electrode 130 and the gate spacer 140 so as to contact the first source/drain area 161. The first source/drain area 161 may be spaced from the gate electrode 130 via the gate spacer 140 and/or the gate dielectric film 120. Hereinafter, the first source/drain area 161 may also be described as an element included in the first active pattern AP1.

A second source/drain area 162 may be disposed on the second active pattern AP2 on sides of the first to fourth gate structures GS1 to GS4. The fourth to sixth bridge patterns 116 to 118 may extend through the gate electrode 130 and the gate spacer 140 so as to contact the second source/drain area 162. The second source/drain area 162 may be spaced from the gate electrode 130 via the gate spacer 140 and/or the gate dielectric film 120. Hereinafter, the second source/drain area 162 may also be described as an element included in the second active pattern AP2.

In some embodiments, each of the first and second source/drain areas 161 and 162 may include an epitaxial layer doped with impurities. For example, each of the first and second source/drain areas 161 and 162 may include an epitaxial pattern grown in an epitaxial growth scheme (i.e., process) from each of the first and second active patterns AP1 and AP2.

When the first active pattern AP1 acts as the channel area of the NFET, the first source/drain area 161 may contain N-type impurities (e.g., P, Sb or As) or impurities to prevent diffusion of the N-type impurities.

When the second active pattern AP2 acts as the channel area of the PFET, the second source/drain area 162 may contain P-type impurities (e.g., B, In, Ga or Al) or impurities to prevent diffusion of the P-type impurities.

In some embodiments, each of the first to fourth gate structures GS1 to GS4 may further include an inner spacer 145. The inner spacer 145 may be formed on a side surface of the gate electrode 130 and between the bridge patterns 111 to 113 and 116 to 118. The first and second source/drain areas 161 and 162 may be spaced from the gate electrode 130 via the gate dielectric film 120, the gate spacer 140 and/or the inner spacer 145. In some embodiments, the inner spacer 145 may be omitted.

The source/drain contacts 171 to 174 may be connected to the first and second active patterns AP1 and AP2. For example, the source/drain contacts 171 to 174 may be in contact with the first and second source/drain areas 161 and 162. The term "contact" (or "contacting," or like terms, such as "connect" or "connecting"), as may be used herein, is intended to refer to a physical and/or electrical connection between two or more elements, and may include other intervening elements. As used herein, the term "and/or" includes any and all combinations of one or more of the associated listed items. The shape and arrangement of the source/drain contacts 171 to 174 are only examples and are not limited to what are shown.

For example, the first source/drain contact 171 may be formed on one side of the first gate structure GS1 opposite to the other side thereof facing the second gate structure GS2. The first source/drain contact 171 may be in contact with the first source/drain area 161 of the first active pattern AP1. In some embodiments, the first source/drain contact 171 may not be in contact with the second source/drain area 162 of the second active pattern AP2. For example, the first source/drain contact 171 may be spaced from the second active pattern AP2 in the first direction X.

For example, the second source/drain contact 172 may be formed between the first gate structure GS1 and the second gate structure GS2. The second source/drain contact 172 may be in contact with the first source/drain area 161 of the first active pattern AP1 and the second source/drain area 162 of the second active pattern AP2. For example, the second source/drain contact 172 may extend in the second direction Y so as to connect the first source/drain area 161 of the first active pattern AP1 and the second source/drain area 162 of the second active pattern AP2 to each other. The second source/drain contact 172 may be provided as an output node of the first inverter INV1.

For example, between the third gate structure GS3 and the fourth gate structure GS4, the third source/drain contact 173 may be formed. The third source/drain contact 173 may be in contact with the first source/drain area 161 of the first active pattern AP1 and the second source/drain area 162 of the second active pattern AP2. For example, the third source/drain contact 173 may extend in the second direction Y so as to connect the first source/drain area 161 of the first active pattern AP1 and the second source/drain area 162 of the second active pattern AP2 to each other. The third source/drain contact 173 may be provided as an output node of the second inverter INV2.

For example, the fourth source/drain contact 174 may be formed on one side of the fourth gate structure GS4 opposite to the other side thereof facing the third gate structure GS3. The fourth source/drain contact 174 may be in contact with the first source/drain area 161 of the first active pattern AP1. In some embodiments, the fourth source/drain contact 174 may not be in contact with the second source/drain area 162 of the second active pattern AP2. For example, the fourth source/drain contact 174 may be spaced apart from the second active pattern AP2 in the first direction X.

The first interlayer insulating film ID1 may fill a space on a side surface of each of the first to fourth gate structure GS1 to GS4. The term "fill" (or "filling," or like terms), as may be used herein, is intended to refer broadly to either completely filling a defined space (e.g., the space on the side surface of each of the first to fourth gate structure GS1 to GS4) or partially filling the defined space; that is, the defined space need not be entirely filled but may, for example, be partially filled or have voids or other spaces throughout. For example, the first interlayer insulating film ID1 may cover the first and second source/drain areas 161 and 162. The second interlayer insulating film ID2 may cover the first to fourth gate structures GS1 to GS4 and the first interlayer insulating film ID1. The term "cover" " (or "covers" or "covering," or like terms), as may be used herein, is intended to broadly refer to a material, layer or structure being on or over another material, layer or structure, but does not require the material, layer or structure to *entirely* cover the other material, layer or structure.

Each of the first interlayer insulating film ID1 and the second interlayer insulating film ID2 may include at least one of, for example, silicon oxide, silicon nitride, silicon oxynitride, silicon oxycarbide, silicon boron nitride, boron silicon carbonitride, silicon oxycarbonitride, and a low dielectric constant material with a dielectric constant lower than that of silicon oxide. However, embodiments of the present disclosure are not limited thereto.

The front area FR may be formed on the first surface 100a of the substrate 100. The front area FR may include a first level front wiring pattern FM1 and a second level front wiring pattern FM2. For example, a front inter-wiring insulating film 200 may be formed on the second interlayer insulating film ID2. The first level front wiring pattern FM1 and the second level front wiring pattern FM2 may be formed within the front inter-wiring insulating film 200 to constitute an electrical path.

The second level front wiring pattern FM2 may be positioned at a higher vertical level than a vertical level of the first level front wiring pattern FM1, relative to the first surface 100a of the substrate 100 as a reference layer. As used herein, "A is positioned at a higher vertical level than a vertical level of B" in the front area FR means that B is closer to the substrate 100 than A is in the vertical direction (hereinafter, a third direction Z). For example, a spacing in the third direction Z between the second level front wiring pattern FM2 and the first surface 100a of the substrate 100 may be larger than a spacing in the third direction Z between the first level front wiring pattern FM1 and the first surface 100a of the substrate 100.

In some embodiments, the first level front wiring pattern FM1 may include first to fourth front wiring patterns 211 to 214 on the unit cell area UC. The first to fourth front wiring patterns 211 to 214 may be positioned at the same vertical level and may be spaced apart from each other and extend in a parallel manner to each other and in the first direction X. For example, each of the first to fourth front wiring patterns 211 to 214 may extend longitudinally in the first direction X, and the first to fourth front wiring patterns 211 to 214 may be arranged sequentially along the second direction Y.

The first front wiring pattern 211 may be connected to the first source/drain contact 171. For example, a first contact via 181 extending through the second interlayer insulating film ID2 so as to connect the first source/drain contact 171 and the first front wiring pattern 211 to each other may be formed. The first front wiring pattern 211 may be provided as a bit-line BL and may be connected to the first pass transistor PS1 via the first source/drain contact 171. In some embodiments, the first front wiring pattern 211 may extend longitudinally in the first direction X beyond the unit cell area UC.

The second front wiring pattern 212 may connect the second gate structure GS2 and the third source/drain contact 173 to each other. For example, a first gate contact 191 may be formed which may extend through the second interlayer insulating film ID2 and the gate capping film 150 so as to connect the gate electrode 130 of the second gate structure GS2 and the second front wiring pattern 212 to each other. Furthermore, for example, a third contact via 183 extending through the second interlayer insulating film ID2 so as to connect the third source/drain contact 173 and the second front wiring pattern 212 to each other may be formed. Via the second front wiring pattern 212, the output node (i.e., the third source/drain contact 173) of the second inverter INV2 may be connected to the input node (i.e., the second gate structure GS2) of the first inverter INV1.

The third front wiring pattern 213 may connect the third gate structure GS3 and the second source/drain contact 172 to each other. For example, a second gate contact 192 may be formed which extends through the second interlayer insulating film ID2 and the gate capping film 150 so as to connect the gate electrode 130 of the third gate structure GS3 and the third front wiring pattern 213 to each other. Furthermore, for example, a second contact via 182 extending through the second interlayer insulating film ID2 so as to connect the second source/drain contact 172 and the third front wiring pattern 213 to each other may be formed. Via the third front wiring pattern 213, the output node (i.e., the second source/drain contact 172) of the first inverter INV1 may be connected to the input node (i.e., the third gate structure GS3) of the second inverter INV2.

The fourth front wiring pattern 214 may be connected to the fourth source/drain contact 174. For example, a fourth contact via 184 extending through the second interlayer insulating film ID2 so as to connect the fourth source/drain contact 174 and the fourth front wiring pattern 214 to each other may be formed. The fourth front wiring pattern 214 may be provided as the complementary bit-line /BL and may be connected to the second pass transistor PS2 via the fourth source/drain contact 174. In some embodiments, the fourth front wiring pattern 214 may extend longitudinally in the first direction X beyond the unit cell area UC.

In some embodiments, the first level front wiring pattern FM1 may further include a fifth front wiring pattern 216 on the tap cell area TC. The fifth front wiring pattern 216 may be positioned at the same vertical level as a vertical level of each of the first to fourth front wiring patterns 211 to 214, relative to the first surface 100a of the substrate 100 as a reference layer.

The fifth front wiring pattern 216 may connect the first gate structure GS1 and the fourth gate structure GS4 on the tap cell area TC to each other. For example, a third gate contact 196 extending through the second interlayer insulating film ID2 and the gate capping film 150 on the tap cell area TC so as to connect the gate electrode 130 of the first gate structure GS1 and the fifth front wiring pattern 216 to each other may be formed. Furthermore, for example, a fourth gate contact 197 extending through the second interlayer insulating film ID2 and the gate capping film 150 on the tap cell area TC so as to connect the gate electrode 130 of the fourth gate structure GS4 and the fifth front wiring pattern 216 to each other may be formed.

In some embodiments, the second level front wiring pattern FM2 may include sixth and seventh front wiring patterns 231 and 232. The sixth and seventh front wiring patterns 231 and 232 may be spaced apart from each other and extend in a parallel manner to each other in the first direction X. For example, each of the sixth and seventh front wiring patterns 231 and 232 may extend in an elongate manner in the first direction X, and the sixth and seventh front wiring patterns 231 and 232 may be arranged sequentially along the second direction Y.

The sixth front wiring pattern 231 may be connected to the first front wiring pattern 211. For example, a first front via pattern 221 extending in the third direction Z so as to connect the first front wiring pattern 211 and the sixth front wiring pattern 231 to each other may be formed. In some embodiments, the sixth front wiring pattern 231 may extend longitudinally in the first direction X beyond the unit cell area UC. In some embodiments, the sixth front wiring pattern 231 may be omitted.

The seventh front wiring pattern 232 may be connected to the fourth front wiring pattern 214. For example, the second front via pattern 222 extending in the third direction Z so as to connect the fourth front wiring pattern 214 and the seventh front wiring pattern 232 to each other may be formed. In some embodiments, the seventh front wiring pattern 232 may extend longitudinally in the first direction X beyond the unit cell area UC. In some embodiments, the seventh front wiring pattern 232 may be omitted.

The back area BR may be formed on the second surface 100b of the substrate 100. The back area BR may include a first level back wiring pattern BM1 and a second level back wiring pattern BM2. For example, a back inter-wiring insulating film 300 may be formed on the second surface 100b of the substrate 100. The first level back wiring pattern BM1 and the second level back wiring pattern BM2 may be formed within the back inter-wiring insulating film 300 to constitute an electrical path.

The second level back wiring pattern BM2 may be positioned at a higher level than a vertical level of the first level back wiring pattern BM1. As used herein, "A is positioned at a higher vertical level than a vertical level of B" in the back area BR means that B is closer to the substrate 100 than A is in the vertical direction (hereinafter, the third direction Z). For example, a spacing in the third direction Z between the second level back wiring pattern BM2 and the second surface 100b of the substrate 100 may be larger than a spacing in the third direction Z between the first level back wiring pattern BM1 and the second surface 100b of the substrate 100.

In some embodiments, the first level back wiring pattern BM1 may include first and second back wiring patterns 311 and 312. The first and second back wiring patterns 311 and 312 may be positioned at the same vertical level, relative to the second surface 100b of the substrate 100. The first and second back wiring patterns 311 and 312 may be spaced apart from each other and extend in a parallel manner to each other in the first direction X. For example, each of the first and second back wiring patterns 311 and 312 may extend longitudinally in the first direction X, and the first and second back wiring patterns 311 and 312 may be arranged sequentially along the second direction Y.

The first back wiring pattern 311 may be connected to a portion of the first source/drain area 161 of the first active pattern AP1 and between the second gate structure GS2 and the third gate structure GS3. For example, a first back source/drain contact 301 which extends through the substrate 100 so as to contact the portion of the first source/drain area 161 disposed between the second gate structure GS2 and the third gate structure GS3 may be formed. The first back wiring pattern 311 may contact the first back source/drain contact 301. The first back wiring pattern 311 may be provided as a first power line that applies a first power voltage (e.g., V_{SS}) to the first pull-down transistor PD1 and the second pull-down transistor PD2. In some embodiments, the first back wiring pattern 311 may extend longitudinally in the first direction X beyond the unit cell area UC.

The second back wiring pattern 312 may be connected to a portion of the second source/drain area 162 of the second active pattern AP2 and between the second gate structure GS2 and the third gate structure GS3. For example, a second back source/drain contact 302 which extends through the substrate 100 so as to contact the portion of the second source/drain area 162 disposed between the second gate structure GS2 and the third gate structure GS3 may be formed. The second back wiring pattern 312 may contact the second back source/drain contact 302. The second back wiring pattern 312 may be provided as a second power line which applies a second power voltage (e.g., V_{DD}) different from the first power voltage (e.g., V_{SS}) to the first pull-up transistor PU1 and the second pull-up transistor PU2. In some embodiments, the second back wiring pattern 312 may extend longitudinally in the first direction X beyond the unit cell area UC.

In some embodiments, the first level back wiring pattern BM1 may further include a third back wiring pattern 316 on the tap cell area TC. The third back wiring pattern 316 may be positioned at the same vertical level as a vertical level of the first and second back wiring patterns 311 and 312.

The third back wiring pattern 316 may be connected to the fifth front wiring pattern 216. For example, a through-contact 176 and 306 which extends through the substrate 100 so as to contact the third back wiring pattern 316 may be formed between the first gate structure GS1 and the fourth gate structure GS4 on the tap cell area TC. Furthermore, for example, a fifth contact via 186 may be formed which extends through the second interlayer insulating film ID2 on the tap cell area TC so as to connect the through-contact 176 and 306 and the fifth front wiring pattern 216 to each other.

In some embodiments, the second level back wiring pattern BM2 may include a fourth back wiring pattern 330. The fourth back wiring pattern 330 may extend in the second direction Y. In some embodiments, the fourth back wiring pattern 330 may extend longitudinally in the second direction Y beyond the unit cell area UC. In some embodiments, the fourth back wiring pattern 330 may extend longitudinally in the second direction Y across the unit cell area UC and tap cell area TC.

The fourth back wiring pattern 330 may be connected to the third back wiring pattern 316. For example, a back via pattern 320 which extends in the third direction Z so as to connect the third back wiring pattern 316 and the fourth back wiring pattern 330 to each other may be formed on the unit tap cell area TC. The fourth back wiring pattern 330 may be provided as the word-line WL, and may be connected to the gate (i.e., the first gate structure GS1) of the first pass transistor PS1 and the gate (i.e., the fourth gate structure GS4) of the second pass transistor PS2 via the third back wiring pattern 316, the through-contact 176 and 306, and the fifth front wiring pattern 216.

In some embodiments, the through-contact 176 and 306 may overlap the first gate structure GS1 and the fourth gate structure GS4 in the first direction X. The term "overlap" (or "overlapping," or like terms), as may be used herein, is intended to broadly refer to a first element that intersects with at least a portion of a second element in the vertical direction (i.e., the third direction Z), but does not require that the first and second elements be completely aligned with one another in a horizontal plane (i.e., the first direction X and/or the second direction Y). In some embodiments, the through-contact 176 and 306 may not overlap with the second gate structure GS2 and the third gate structure GS3 in the first direction X.

In some embodiments, the through-contact 176 and 306 may include a front through-contact 176 and a back through-contact 306. The front through-contact 176 may connect the back through-contact 306 and the fifth contact via 186 to each other. The back through-contact 306 may connect the third back wiring pattern 316 and the front through-contact 176 to each other. In some embodiments, the front through-contact 176 may be formed at the same vertical level as that of each of the source/drain contacts 171 to 174 of the unit cell area UC. The back through-contact 306 may be formed at the same vertical level as that of each of the back source/drain contacts 301 and 302 of the unit cell area UC. As used herein, "being formed at the same vertical level" means being formed in the same manufacturing process.

In some embodiments, an element isolation pattern 107, a first insulating structure IS1 and a second insulating structure IS2 may be formed on the tap cell area TC.

The element isolation pattern 107 may be formed within the substrate 100 of the tap cell area TC. The element isolation pattern 107 may include, for example, at least one of silicon oxide, silicon nitride, silicon oxynitride, silicon oxycarbide, silicon boron nitride, silicon boron carbonitride, silicon oxycarbonitride, or combinations thereof. However, embodiments of the present disclosure are not limited thereto.

In some embodiments, the through-contact 176 and 306 may extend through the element isolation pattern 107 so as to connect the third back wiring pattern 316 and the fifth front wiring pattern 216 to each other.

The first and second insulating structures IS1 and IS2 may be formed on the substrate 100 of the tap cell area TC and/or the element isolation pattern 107. The first and second insulating structures IS1 and IS2 may be interposed between the first gate structure GS1 and the fourth gate structure GS4. The first and second insulating structures IS1 and IS2 may be spaced apart from each other and extend in a parallel manner to each other in the second direction Y. In some embodiments, the first insulating structure IS1 and the second gate structure GS2 on the unit cell area UC may be arranged along the second direction Y. The second insulating structure IS2 and the third gate structure GS3 on the unit cell area UC may be arranged along the second direction Y.

In some embodiments, the through-contact 176 and 306 may be interposed between the first insulating structure IS1 and the second insulating structure IS2.

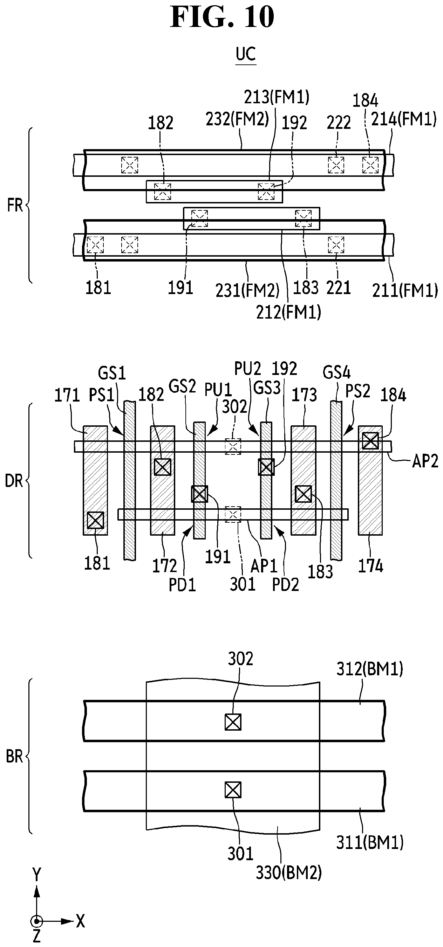

FIG. 10 is an example schematic layout diagram illustrating the unit cell area of the semiconductor device according to some embodiments. For convenience of description, contents that are repeated with those as described above in connection with FIG. 1 to FIG. 9 are briefly described or descriptions thereof are omitted.

Referring to FIG. 10, in a semiconductor device according to some embodiments, the second active pattern AP2 intersects the first gate structure GS1 and the fourth gate structure GS4.

The first gate structure GS1 may serve as the gate of the first pass transistor PS1. For example, the area of the second active pattern AP2 that intersects the first gate structure GS1 may serve as the channel area of the first pass transistor PS1.

The fourth gate structure GS4 may serve as the gate of the second pass transistor PS2. For example, the area of the second active pattern AP2 that intersects the fourth gate structure GS4 may serve as the channel area of the second pass transistor PS2.

The first source/drain contact 171 may be in contact with the second active pattern AP2. In some embodiments, the first source/drain contact 171 may not be in contact with the first active pattern AP1. For example, the first source/drain contact 171 may be spaced from the first active pattern AP1 in the first direction X.

The fourth source/drain contact 174 may be in contact with the second active pattern AP2. In some embodiments, the fourth source/drain contact 174 may not be in contact with the first active pattern AP1. For example, the fourth source/drain contact 174 may be spaced apart from the first active pattern AP1 in the first direction X.

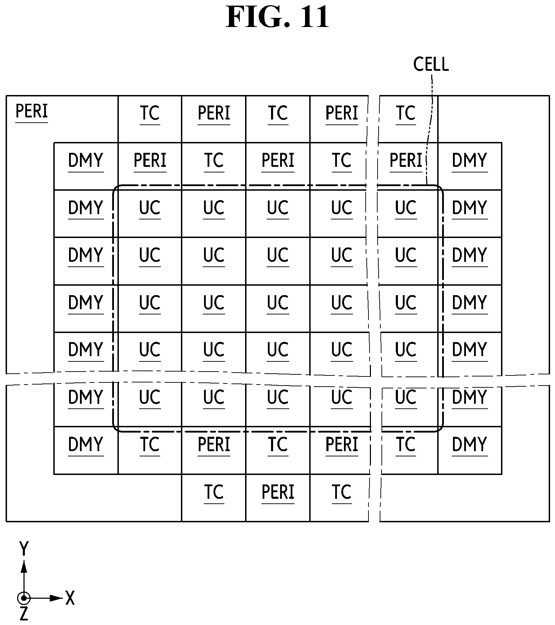

FIG. 11 is an example block diagram for illustrating a semiconductor device according to some embodiments. For convenience of description, contents that are repeated with those as described above using FIG. 1 to FIG. 10 are briefly described or descriptions thereof are omitted.

Referring to FIG. 11, in a semiconductor device according to some embodiments, a plurality of tap cell areas TC are arranged in a staggered manner in the first direction X and/or the second direction Y.

For example, the tap cell areas TC may be arranged alternately in the second direction Y in the peripheral area PERI and/or the dummy cell area DMY. In some embodiments, at least a portion of the peripheral area PERI and/or at least a portion of the dummy cell area DMY may be interposed between a plurality of unit cell areas UC arranged along the second direction Y and the top cell area TC.

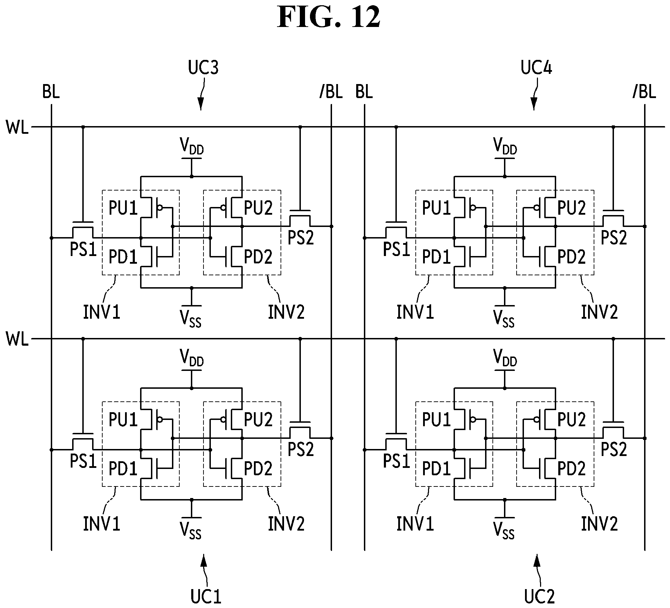

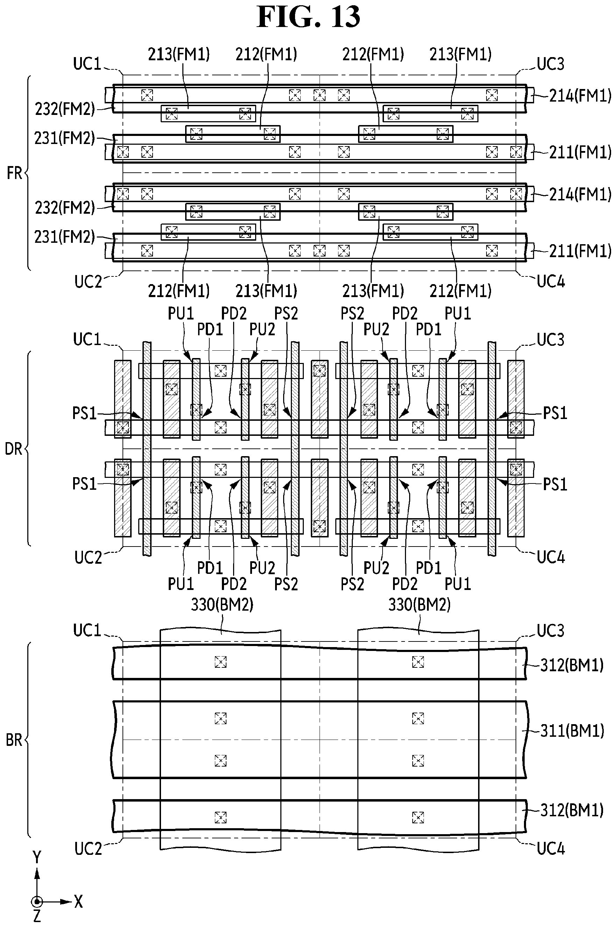

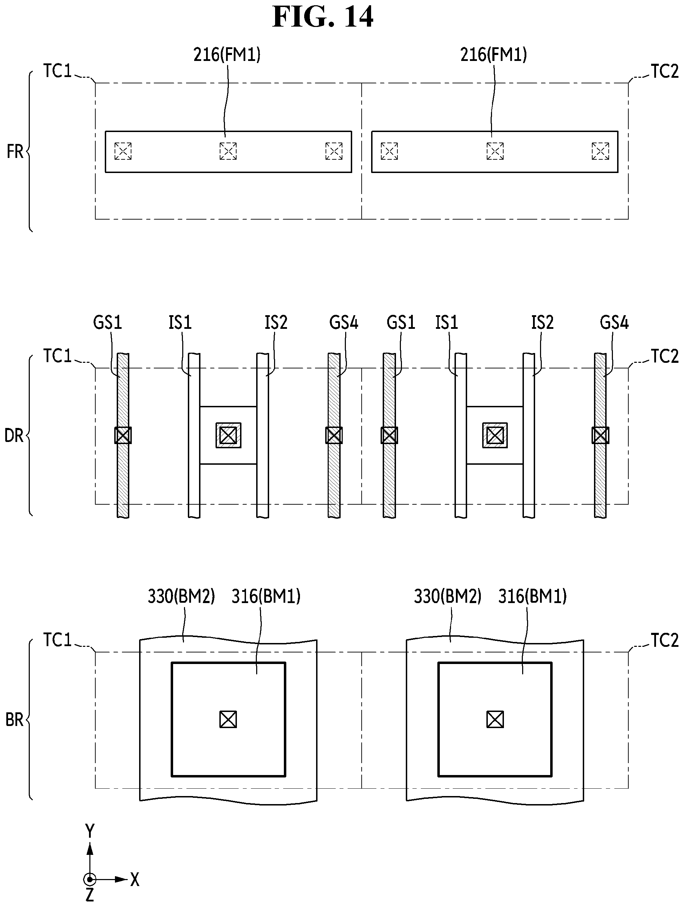

FIG. 12 is a circuit diagram illustrating a semiconductor device according to some embodiments. FIG. 13 and FIG. 14 are example schematic layouts for illustrating the semiconductor device in FIG. 12. For convenience of description, contents that are repeated with those as described above in connection with FIG. 1 to FIG. 11 are briefly described or descriptions thereof are omitted.

Referring to FIG. 12, the semiconductor device according to some embodiments include first to fourth unit cell areas UC1 to UC4 adjacent to each other.

Each of the first to fourth unit cell areas UC1 to UC4 may include a pair of inverters INV 1 and INV2 connected in parallel with each other and disposed between and connected to the power node V_{DD} and the ground node V_{SS}, and the first pass transistor PS1 and the second pass transistor PS2 respectively connected to the respective output nodes of the inverters INV1 and INV2. Since each of the first to fourth unit cell areas UC1 to UC4 is the same as described above using FIG. 2, detailed descriptions thereof are omitted below.

In some embodiments, the first unit cell area UC1 and the second unit cell area UC2 may share one word-line WL. The third unit cell area UC3 and the fourth unit cell area UC4 may share another word-line WL. For example, the gates of the pass transistors PS1 and PS2 of the first unit cell area UC1 and the gates of the pass transistors PS1 and PS2 of the second unit cell area UC2 may be commonly connected to one word-line WL. Furthermore, the gates of the pass transistors PS1 and PS2 of the third unit cell area UC3 and the gates of the pass transistors PS1 and PS2 of the fourth unit cell area UC4 may be commonly connected to another word-line WL.

In some embodiments, the first unit cell area UC1 and the third unit cell area UC3 may share one bit-line BL and one complementary bit-line /BL. The second unit cell area UC2 and the fourth unit cell area UC4 may share one bit-line BL and one complementary bit-line /BL. For example, the first pass transistor PS1 of the first unit cell area UC1 and the first pass transistor PS1 of the third unit cell area UC3 may be commonly connected to one bit-line BL. The second pass transistor PS2 of the first unit cell area UC1 and the second pass transistor PS2 of the third unit cell area UC3 may be commonly connected to one complementary bit-line /BL. Furthermore, the first pass transistor PS1 of the second unit cell area UC2 and the first pass transistor PS1 of the fourth unit cell area UC4 may be commonly connected to another bit-line BL. The second pass transistor PS2 of the second unit cell area UC2 and the second pass transistor PS2 of the fourth unit cell area UC4 may be commonly connected to another complementary bit-line /BL.

Referring to FIG. 12 to FIG. 14, in the semiconductor device according to some embodiments, each of the first to fourth unit cell areas UC1 to UC4 may include the element area DR, the front area FR, and the back area BR. Since each of the first to fourth unit cell areas UC1 to UC4 in FIG. 13 is the same as described above using FIG. 3, detailed descriptions thereof are omitted below. Furthermore, since each of the first and second tap cell areas TC1 and TC2 in FIG. 14 is the same as described above using FIG. 8, detailed descriptions thereof are omitted below.

The first unit cell area UC1 and the second unit cell area UC2 may have a plane-symmetric relationship with respect to each other around a plane intersecting the second direction Y (i.e., a XZ plane). The third unit cell area UC3 and the fourth unit cell area UC4 may have a plane-symmetric relationship with respect to each other around a plane intersecting the second direction Y (i.e., a XZ plane). The first unit cell area UC1 and the third unit cell area UC3 may have a plane-symmetric relationship with respect to each other around a plane intersecting the first direction X (i.e., a YZ plane). The second unit cell area UC2 and the fourth unit cell area UC4 may have a plane-symmetric relationship with respect to each other around a plane intersecting the first direction X (i.e., a YZ plane).

The first front wiring patterns 211 and the fourth front wiring patterns 214 may be arranged alternately with each other and repeatedly along the second direction Y. One first front wiring pattern 211 may extend in the first direction X and thus may act as one bit-line BL commonly connected to the first unit cell area UC1 and the third unit cell area UC3. Another first front wiring pattern 211 may extend in the first direction X and may act as another bit-line BL commonly connected to the second unit cell area UC2 and the fourth unit cell area UC4. One fourth front wiring pattern 214 may extend in the first direction X and may act as one complementary bit-line /BL commonly connected to the first unit cell area UC1 and the third unit cell area UC3. Another fourth front wiring pattern 214 may extend in the first direction X and may act as another complementary bit-line /BL commonly connected to the second unit cell area UC2 and the fourth unit cell area UC4.

The first back wiring patterns 311 and the second back wiring patterns 312 may be arranged alternately with each other and repeatedly along the second direction Y. One first back wiring pattern 311 may extend in the first direction X and may act as one first power line (e.g., V_{SS}) commonly connected to the first to fourth unit cell areas UC1 to UC4. One second back wiring pattern 312 may extend in the first direction X and may act as one second power line (e.g., V_{DD}) commonly connected to the first unit cell area UC1 and the third unit cell area UC3. Another second back wiring pattern 312 may extend in the first direction X and may act as another second power line (e.g., V_{DD}) commonly connected to the second unit cell area UC2 and the fourth unit cell area UC4.

The fourth back wiring patterns 330 may be repeatedly arranged along the first direction X. One fourth back wiring pattern 330 may be provided as one word-line WL. Another fourth back wiring pattern 330 may be provided as another word-line WL.

The first tap cell area TC1 and the first and second unit cell areas UC1 and UC2 may be arranged along the second direction Y. The fifth front wiring pattern 216 of the first tap cell area TC1 may be connected to the one fourth back wiring pattern 330. Furthermore, the fifth front wiring pattern 216 of the first tap cell area TC1 may connects the first and fourth gate structures GS1 and GS4 extending from the first and second unit cell areas UC1 and UC2 to each other. Thus, the first unit cell area UC1 and the second unit cell area UC2 may share the one word-line WL.

The second tap cell area TC2 and the third and fourth unit cell areas UC3 and UC4 may be arranged along the second direction Y. The fifth front wiring pattern 216 of the second tap cell area TC2 may be connected to another fourth back wiring pattern 330. Furthermore, the fifth front wiring pattern 216 of the second tap cell area TC2 may connect the first and fourth gate structures GS1 and GS4 extending from the third and fourth unit cell areas UC3 and UC4 to each other. Thus, the third unit cell area UC3 and the fourth unit cell area UC4 may share another word-line WL.

As the semiconductor device becomes more highly integrated, individual circuit patterns are becoming more refined to place a larger number of semiconductor devices in the same area. For this purpose, a backside power delivery network (BSPDN) in which a power delivery network is disposed on the back surface of the substrate is being studied.

The semiconductor device according to some embodiments provides a layout in which the BSPDN is efficiently used. For example, a SRAM device including two channel patterns (e.g., the first and second active patterns AP1 and AP2) and four gate patterns (e.g., the first to fourth gate structures GS 1 to GS4) per unit cell area UC may be provided. As described above, the front wiring pattern (e.g., FM1 or FM2) may act as each of the bit-line BL and the complementary bit-line /BL of each unit cell area UC. The back wiring pattern (e.g., BM1 or BM2) may act as each of the word-line WL, the first power line (e.g., V_{SS}), and the second power line (e.g., V_{DD}) of each unit cell area UC. Furthermore, as described above, in the semiconductor device according to some embodiments, each unit cell area UC may be controlled by a pair of bit-lines BL and /BL and one word-line WL. Thus, the semiconductor device with an improved degree of freedom (DOF) in design and an improved integration density may be provided.

Although embodiments of the present disclosure have been described with reference to the accompanying drawings, the present disclosure is not limited to the above embodiments, but may be implemented in various different forms. A person skilled in the art may appreciate that the present disclosure may be practiced in other concrete forms. Therefore, it should be appreciated that the embodiments as described above is not restrictive but illustrative in all respects.

## Claims

1. A semiconductor device, comprising:
a substrate including a first surface and a second surface opposite to each other;
first and second active patterns on the first surface, the first and second active patterns extending in a first direction parallel to the first surface of the substrate;
first, second, third and fourth gate structures arranged sequentially along the first direction on the first and second active patterns, the first, second, third and fourth gate structures extending in a second direction intersecting the first direction and parallel to the first surface of the substrate;
a first source/drain contact between the first gate structure and the second gate structure, the first source/drain contact electrically connecting the first active pattern and the second active pattern;
a second source/drain contact between the third gate structure and the fourth gate structure, the second source/drain contact electrically connecting the first active pattern and the second active pattern;
a third source/drain contact connected to the first active pattern, the first gate structure being between the first source/drain contact and the third source/drain contact;
a fourth source/drain contact connected to the first active pattern, the fourth gate structure being between the second source/drain contact and the fourth source/drain contact;
a first front wiring pattern extending in the first direction on the first surface and connected to the third source/drain contact;
a second front wiring pattern extending in the first direction on the first surface and electrically connecting the second gate structure and the second source/drain contact;
a third front wiring pattern extending in the first direction on the first surface and electrically connecting the third gate structure and the first source/drain contact;
a fourth front wiring pattern extending in the first direction on the first surface and connected to the fourth source/drain contact;
a first back wiring pattern extending in the first direction on the second surface and connected to the first active pattern between the second gate structure and the third gate structure;
a second back wiring pattern extending in the first direction on the second surface and connected to the second active pattern between the second gate structure and the third gate structure; and
a third back wiring pattern extending in the second direction on the second surface and commonly connected to the first gate structure and the fourth gate structure.

2. The semiconductor device of claim 1, further comprising:
a fifth front wiring pattern extending in the first direction on the first surface and electrically connecting the first gate structure and the fourth gate structure; and
a through-contact between the first gate structure and the fourth gate structure, the through-contact extending in the substrate and electrically connecting the third back wiring pattern and the fifth front wiring pattern.

3. The semiconductor device of claim 2, wherein the through-contact is non-overlapping with the second gate structure and the third gate structure in the first direction.

4. The semiconductor device of claim 2 or claim 3, wherein the substrate includes a first area and a second area arranged along the second direction,
wherein the first and second active patterns are on the first area,
wherein the fifth front wiring pattern is on the second area,
wherein each of the first gate structure and the fourth gate structure extends in the second direction across the first area and the second area.

5. The semiconductor device of any preceding claim, further comprising:
a first back source/drain contact extending through the substrate and electrically connecting the first active pattern between the second gate structure and the third gate structure to the first back wiring pattern; and
a second back source/drain contact extending through the substrate and electrically connecting the second active pattern between the second gate structure and the third gate structure to the second back wiring pattern.

6. The semiconductor device of any preceding claim, wherein the first, second, third and fourth front wiring patterns are positioned at the same vertical level, relative to the first surface of the substrate as a reference layer.

7. The semiconductor device of claim 6, wherein the first, second, third and fourth front wiring patterns are sequentially arranged along the second direction.

8. The semiconductor device of claim 6 or claim 7, further comprising:
a sixth front wiring pattern extending in the first direction on the first surface and connected to the first front wiring pattern; and
a seventh front wiring pattern extending in the first direction on the first surface and connected to the fourth front wiring pattern,
wherein a spacing between each of the sixth and seventh front wiring patterns and the first surface of the substrate is greater than a spacing between each of the first, second, third and fourth front wiring patterns and the first surface of the substrate.

9. The semiconductor device of any preceding claim, wherein the first and second back wiring patterns are positioned at the same vertical level, relative to the first surface of the substrate as a reference layer.

10. The semiconductor device of claim 9, wherein a spacing between the third back wiring pattern and the second surface of the substrate is greater than a spacing between each of the first and second back wiring patterns and the second surface of the substrate.

11. The semiconductor device of any preceding claim, wherein each of the third and fourth source/drain contacts is spaced apart from the second active pattern in the first direction.

12. The semiconductor device of any preceding claim, wherein each of the first and second active patterns includes a plurality of bridge patterns sequentially stacked on the substrate and spaced apart from each other in a third direction perpendicular to the first surface of the substrate.

13. The semiconductor device of any preceding claim, wherein a first power voltage is applied to the first back wiring pattern, and
wherein a second power voltage different from the first power voltage is applied to the second back wiring pattern.

14. A semiconductor device including a first area and a second area arranged along a first direction, the semiconductor device comprising:
a substrate including a first surface and a second surface opposite to each other;
first and second active patterns on the first surface of the first area, the first and second active patterns extending in a second direction parallel to the first surface of the substrate and intersecting the first direction in a parallel manner;
first, second, third and fourth gate structures arranged sequentially along the second direction on the first and second active patterns, the first, second, third and fourth gate structures extending in the first direction in a parallel manner;
a first front wiring pattern extending in the second direction on the first surface of the first area and connected to the first active pattern on one side of the first gate structure;
a second front wiring pattern extending in the second direction on the first surface of the first area and connected to the first active pattern on one side of the fourth gate structure;
a third front wiring pattern extending in the second direction on the first surface of the second area and electrically connecting the first gate structure and the fourth gate structure;
a first back wiring pattern extending in the second direction on the second surface of the first area and connected to the first active pattern between the second gate structure and the third gate structure;
a second back wiring pattern extending in the second direction on the second surface of the first area and connected to the second active pattern between the second gate structure and the third gate structure;
a third back wiring pattern extending in the first direction on the second surface of the first area and the second area; and
a through-contact extending through the substrate of the second area and electrically connecting the third front wiring pattern and the third back wiring pattern.

15. The semiconductor device of claim 14, further comprising:
a first back source/drain contact extending through the substrate and electrically connecting the first active pattern between the second gate structure and the third gate structure to the first back wiring pattern; and
a second back source/drain contact extending through the substrate and electrically connecting the second active pattern between the second gate structure and the third gate structure to the second back wiring pattern.
